# EUROPÄISCHE PATENTANMELDUNG

(11) **EP 4 715 846 A1**
(43) Veröffentlichungstag der Anmeldung: **25.03.2026**
(21) Anmeldenummer: 25198407.6
(22) Anmeldetag: 27.08.2025
(51) Int. Cl.: H01B 17/30, H02G 3/08, H02G 15/013, H05K 5/02, H02G 3/22

(54) **ELEKTRISCHE DURCHFÜHRUNG UND VERFAHREN ZU DEREN HERSTELLUNG**

(30) Priorität: 06.09.2024 DE 102024125575
(71) Anmelder: SCHOTT AG, 55122 Mainz (DE)
(72) Erfinder: HARTL, Helmut, 1210 Wien (AT)
(74) Vertreter: Schott Corporate IP

(57) **Zusammenfassung**

Es wird eine elektrische Durchführung (1) bereitgestellt umfassend einen Grundkörper (10) mit mindestens einer Öffnung (12), durch die ein elektrischer Leiter (30) hindurchgeführt ist und in der Öffnung (12) über ein Fixiermaterial (20) gehalten ist, wobei das Fixiermaterial (20) die Öffnung (12) verschließt und wobei der Grundkörper (10) eine längliche Form aufweist und zumindest an den Rändern der langen Seiten eine Verstärkungsstruktur aufweist. Die Verstärkungsstruktur ist als erhöhter Randbereich (16) ausgeführt ist, der gegenüber einer Grundebene (11) des Grundkörpers (10) vertikal versetzt ist.

## Beschreibung

Die Erfindung betrifft eine elektrische Durchführung umfassend einen Grundkörper mit zumindest einer Öffnung und einen durch die Öffnung hindurchgeführten elektrischen Leiter, wobei der Leiter in der Öffnung mit einem Fixiermaterial gehalten ist und das Fixiermaterial die Öffnung abdichtet, der Grundkörper eine längliche Form aufweist und zumindest an den Rändern der langen Seiten eine Verstärkungsstruktur aufweist. Ein Weiterer Aspekt der Erfindung betrifft ein Verfahren zur Herstellung einer solchen elektrischen Durchführung.

### Stand der Technik

Gehäuse für elektrische oder elektronische Komponenten erfordern in der Regel eine Vielzahl von elektrischen Durchführungen, um elektrische Verbindungen von außen in das Innere des Gehäuses zu ermöglichen, in dem sich z. B. Teile eines elektrischen Kompressors (E-Kompressor) befinden. Die elektrischen Durchführungen müssen flüssigkeitsdicht oder sogar hermetisch dicht sein, um die Komponenten im Gehäuse vor der Umgebung zu schützen und/oder Gase oder Flüssigkeiten im Inneren des Gehäuses zu halten. Um solche flüssigkeitsdichten oder hermetischen Durchführungen für einen elektrischen Leiter zu erhalten, der in einer Öffnung des Gehäuses angeordnet ist, können Metall-Fixiermaterial-Durchführungen verwendet werden. Ein Fixiermaterial, beispielsweise ein Glasmaterial, wird dabei verwendet, um die Öffnung abzudichten und den Leiter in der Öffnung zu halten. Das Fixiermaterial sorgt auch für eine elektrische Isolierung zwischen dem Leiter und dem Gehäuse.

Bei den bekannten Durchführungen bildet ein im Wesentlichen plattenförmiges Element einen Grundkörper aus, durch den die elektrischen Leiter hindurchgeführt sind. Dieser Grundkörper wiederum kann dann in eine Öffnung eines Gehäuses eines elektrischen oder elektronischen Geräts eingesetzt werden, wie beispielsweise einem E-Kompressor. Um eine Abdichtung zwischen dem Grundkörper und dem Gehäuse zu gewährleisten, müssen Dichtflächen am Grundkörper eben sein. Entsprechend darf der Grundkörper sich nicht verbiegen, wenn dieser am Gehäuse, beispielsweise über eine Schraubverbindung, befestigt wird.

Aus WO2021070817A1 ist eine elektrische Durchführung bekannt, bei der ein Außenleiter bzw. Grundkörper rahmenförmige oder balkenförmige Verlängerungsabschnitte als Verstärkungsstruktur aufweist. Diese kann den gesamten Außenleiter umgeben oder nur an Längsseiten eines plattenförmigen Grundkörpers angeordnet sein.

Zur Herstellung der rahmenförmigen oder balkenförmigen Verlängerungsabschnitte wird ein zunächst plattenförmiger Grundkörper mittels eines mehrstufigen Ziehprozesses umgeformt, beispielsweise unter Verwendung von Tiefziehen. Diese Ziehprozesse sind aufwändig und erfordern zusätzliches Material für den Grundkörper.

Eine Aufgabe der Erfindung ist das Bereitstellen einer elektrischen Durchführung mit einem Grundkörper mit einer Verstärkungsstruktur, welche materialsparend ist und sich einfach fertigen lässt.

### Offenbarung der Erfindung

Es wird eine elektrische Durchführung vorgeschlagen. Die elektrische Durchführung umfasst einen Grundkörper mit mindestens einer Öffnung, durch die ein elektrischer Leiter hindurchgeführt ist und in der Öffnung über ein Fixiermaterial gehalten ist, wobei das Fixiermaterial die Öffnung verschließt und wobei der Grundkörper eine längliche Form aufweist und zumindest an den Rändern der langen Seiten eine Verstärkungsstruktur aufweist. Ferner ist vorgesehen, dass die Verstärkungsstruktur als erhöhter Randbereich ausgeführt ist, der gegenüber einer Grundebene des Grundkörpers vertikal versetzt ist.

Bevorzugt ist der erhöhte Randbereich vertikal gegenüber einer Grundebene des Grundkörpers versetzt, wobei eine Stärke S1 des Randbereichs einer Dicke D des Grundkörpers entspricht. Hierzu kann der erhöhte Randbereich mittels Schubumformen umgeformt sein. Das führt dazu, dass eine Verbindungsstelle bzw. ein Anbindungsbereich zwischen dem erhöhten Randbereich und dem Rest des Grundkörpers eine geringere Höhe aufweist als die Dicke des Grundkörpers.

Der Grundkörper besteht bevorzugt aus einem Metallmaterial, wobei der erhöhte Randbereich mittels Schubumformen aus einem flachen Rohling erhalten wurde. Die Grundebene ist dabei insbesondere eine Ebene, welche durch die Längsrichtung und Querrichtung aufgespannt wird bzw. senkrecht zu einer Achse der Öffnungen im Grundkörper orientiert ist und an den Randbereich angrenzt. Entsprechend wird durch das vertikale Versetzen Material des Grundkörpers senkrecht zu der Grundebene verschoben.

Durch das vertikale Verschieben bzw. das Schubumformen zum Erhalten des erhöhten Randbereichs wird ein Faserverlauf des Metallmaterials des Grundkörpers an der Verbindungsstelle verdichtet und oberhalb bzw. unterhalb der Verbindungsstelle abgetrennt. Metallteile, insbesondere umgeformte Metallteile, weisen eine faserähnliche Struktur auf, welche als Faserverlauf oder metallurgische Fließlinien bezeichnet wird. Der Faserverlauf kann beispielsweise an einem Schnitt durch das Metallteil mit einem nasschemischen Ätzprozess sichtbar gemacht werden. Der Faserverlauf und dabei insbesondere dessen Richtung, wird durch Umformprozesse beeinflusst. Bei dem vorgeschlagenen vertikalen Verschieben bzw. Schubumformen bleibt auch nach dem Verschieben des Materials die Richtung des Faserverlaufs erhalten, während z.B. bei einem Tiefziehprozess die Richtung verändert wird.

Da das Metallmaterial parallel zu dem Faserverlauf seine größte mechanische Stabilität aufweist ist vorgesehen, die längste Seite des Grundkörpers, welche entsprechend der größten Gefahr eines Verzugs oder eines Verbiegens ausgesetzt ist, parallel zu dem Faserverlauf auszurichten. Dadurch wird ohne zusätzlichen Materialeinsatz die Biegesteifigkeit entlang der längsten Richtung des Grundkörpers verbessert.

Der Grundkörper weist eine längliche Form auf. Mit länglicher Form ist dabei insbesondere gemeint, dass der Grundkörper eine Längsseite mit einer Länge und eine Querseite mit einer Breite aufweist, wobei die Länge größer ist als die Breite. Der Grundkörper ist bevorzugt plattenförmig ausgebildet. Mit plattenförmig ist dabei insbesondere gemeint, dass der Grundkörper eine Dicke aufweist, die kleiner ist als eine Länge und eine Breite des Grundkörpers.

Der Grundkörper weist bevorzugt eine im Wesentlichen rechteckige Grundform auf mit einer langen Längsseite, einer kürzeren Querseite auf. Mit im Wesentlichen rechteckiger Grundform sind neben einer rein rechteckigen Form insbesondere auch Formen gemeint, welche länglich sind und Verrundungen enthalten, wie beispielsweise ein Rechteck mit abgerundeten Ecken oder eine Form mit zwei parallelen und geraden langen Seiten und gebogenen kurzen Seiten. Der erhöhte Randbereich ist bevorzugt zumindest an den Kanten der Längsseiten angeordnet, wobei der Randbereich dabei über die gesamte Länge der Längsseite angeordnet sein kann. Der Randbereich kann aber auch unterbrochen sein und/oder nur an einem Teil der Längsseiten angeordnet sein. Des Weiteren kann der erhöhte Randbereich auch an den Querseiten angeordnet sein, wobei wiederum der erhöhte Rand über die gesamte Länge der Querseite angeordnet sein kann, aber auch unterbrochen sein kann und/oder nur an einem Teil der Querseite angeordnet sein kann. Bevorzugt ist der erhöhte Randbereich wie ein Verstärkungsring vollständig um die Außenkontur des Grundkörpers herum angeordnet.

Durch das vertikale Verschieben des Materials zum Erhalten des erhöhten Randbereichs entsteht an der Unterseite des Grundkörpers komplementär dazu eine Stufe. Diese Stufe kann als ein mechanischer Anschlag bzw. als eine Zentrierhilfe dienen, wenn die Durchführung mit dem Grundkörper in eine Öffnung eines Gehäuses eingesetzt wird. Die relative Position der elektrischen Durchführung zu dem Gehäuse kann dadurch genauer festgelegt werden und eine Montage der elektrischen Durchführung wird erleichtert.

An der Oberseite des Grundkörpers bildet der erhöhte Randbereich eine Wand aus. Diese kann als ein mechanischer Anschlag bzw. als eine Zentrierhilfe für ein zusätzliches Isolationselement dienen, welches auf die elektrische Durchführung aufgesetzt wird. Ein solches zusätzliches Isolationselement, welches beispielsweise aus einem elastischen Material oder einem thermoplastischen oder duroplastischen Kunststoff gefertigt ist, kann verwendet werden, um eine Isolationsstrecke oder Kriechstrecke zwischen einem der durchgeführten elektrischen Leiter und dem Grundkörper der Durchführung zu verlängern.

Bevorzugt ist um die mindestens eine Öffnung herum ein erhöhter oder vertiefter Verstärkungsbereich ausgebildet, wobei der erhöhte oder vertiefte Verstärkungsbereich vertikal gegenüber einer Grundebene des Grundkörpers versetzt ist und wobei eine Stärke S2 des erhöhten oder vertieften Verstärkungsbereichs einer Dicke D des Grundkörpers entspricht. Der Verstärkungsbereich kann wie der Randbereich mittels Schubumformen erhalten werden.

Weist der Grundkörper mehr als eine Öffnung auf, kann für jede der Öffnungen jeweils ein eigener erhöhter oder vertiefter Verstärkungsbereich vorgesehen sein. Alternativ dazu kann auch ein einziger erhöhter oder vertiefter Verstärkungsbereich vorgesehen sein, der alle Öffnungen zur Durchführung eines elektrischen Leiters umfasst. Die Befestigungsöffnungen, sofern vorhanden, können dabei außerhalb des erhöhten oder vertieften Verstärkungsbereichs liegen.

Da der Randbereich und ggf. der Verstärkungsbereich nur durch vertikales Verschieben des Materials des Grundkörpers gegenüber einer Grundebene des Grundkörpers erhalten werden, ist zum Ausbilden dieser Bereiche kein zusätzliches Material erforderlich. Die Materialmenge entspricht genau dem eines flachen Grundkörpers mit denselben Abmessungen in Länge und Breite bei einer rechteckigen Grundform bzw. Durchmesser im Fall einer runden Grundform. Dennoch wird die mechanische Stabilität des Grundkörpers gesteigert und insbesondere eine Resistenz gegen ein Verbiegen des Grundkörpers erhöht.

Insbesondere bei Herstellung mittels Schubumformen ist der erhöhte Randbereich und/oder der erhöhte oder vertiefte Verstärkungsbereich um weniger als die Dicke D des Grundkörpers gegenüber einer Grundebene des Grundkörpers versetzt. Die Grundebene ist dabei die ursprüngliche, vor dem Anwenden des Umformens vorhandene Ebene an der Oberfläche des plattenförmigen Grundkörpers bzw. eines Rohlings des Grundkörpers und entspricht nach dem Schubumformen der Ebene, die an den erhöhten Randbereich angrenzt.

Bevorzugt ist der erhöhte Randbereich und/oder der erhöhte oder vertiefte Verstärkungsbereich in Bezug auf die Dicke D des Grundkörpers im Bereich von 20 % bis 80% in vertikaler Richtung versetzt.

Durch Schubumformen kann dann der Grundkörper aus einem flachen Rohling erhalten werden, wobei der Rohling die Dicke D aufweist und bereits die Länge und Breite bzw. den Durchmesser des fertigen Grundkörpers aufweist. Eine Oberfläche des Rohlings kann dann als Grundebene angesehen werden. Der Randbereich und/oder der Verstärkungsbereich können dann durch vertikales Verschieben gegenüber der Grundebene des Rohlings erhalten werden.

Da der erhöhte Randbereich und, sofern vorhanden, der Verstärkungsbereich durch vertikales Verschieben von Material des Rohlings erhalten werden, weist der Grundkörperüber alle Bereiche, also den Randbereich, den Verstärkungsbereich und einen unbearbeiteten Grundbereich, dieselbe konstante Dicke D auf. Es wird kein zusätzliches Material benötigt, um den Randbereich und/oder den Verstärkungsbereich auszubilden.

Eine Weite W des Randbereichs kann durch das Fertigen mittels Schubumformen frei gewählt werden und liegt bevorzugt im Bereich vom 0,5 fachen bis zum doppelten der Dicke D des Grundkörpers.

Bevorzugt ist der Grundkörper aus Metall gefertigt, wobei das Metall bevorzugt ausgewählt ist aus der Gruppe umfassend Stahl, insbesondere unlegierten Stahl wie einem Stahl mit der Materialnummer 1.0338 oder Edelstahl, NiFe, Kovar, Titan und Kupfer.

Bevorzugt ist der Grundkörper mit einer Oberflächenbeschichtung versehen, insbesondere einer Nickelschicht. Mit der Beschichtung kann die Widerstandsfähigkeit des Materials des Grundkörpers insbesondere gegen korrosive Umwelteinflüsse gesteigert werden.

Bei der Oberflächenbeschichtung handelt es sich bevorzugt um eine Nickelschicht, welche galvanisch oder chemisch auf der Oberfläche des Metallmaterials des Grundkörpers abgeschieden werden kann. Im Fall einer galvanischen Beschichtung wird die Beschichtung bevorzugt durch Trommelbeschichten erhalten. Die Beschichtung ist bevorzugt auf der gesamten Oberfläche des Grundkörpers angeordnet und ist bevorzugt frei von Lücken oder Fehlstellen.

Bevorzugt weist der Grundkörper einen Dichtungsbereich auf, der glatt, also frei von Kratzern und Kerben ist und somit gut geeignet ist, mit einem Dichtmittel wie einem O-Ring gegen ein Gehäuse abzudichten. Des Weiteren ist der Dichtungsbereich des Grundkörpers bevorzugt eben ausgestaltet, wobei der Dichtungsbereich bevorzugt eine Abweichung der Ebenheit ≤ 0,1 mm gemäß DIN EN ISO 1101, Stand 09/2017, insbesondere im Bereich 0,005 mm bis 0,02 mm pro 10 mm Länge aufweist.

Bevorzugt ist der Grundkörper entlang des gesamten äußeren Rands und damit entlang aller Kanten der Außenkontur des Grundkörpers mit einer Fase und/oder einer Verrundung versehen. Mit den Kanten der Außenkontur bzw. des äußeren Rands sind insbesondere diejenigen Kanten umfasst, welche den Übergang von der Oberseite bzw. der Unterseite des Grundkörpers zu einem vertikalen Rand des Grundkörpers bilden. Die Verrundung der Kanten der Außenkontur weist bevorzugt einen Radius r im Bereich von 0,1 mm bis 2 mm, besonders bevorzugt im Bereich von 0,5 mm bis 1,5 mm, am meisten bevorzugt von 0,75 mm bis 1,0 mm auf. Im Fall einer Fase wird ein gestufter Übergang zwischen der Oberseite bzw. der Unterseite und dem vertikalen Rand geschaffen, wobei anstelle eines Winkels von ca. 90° der Übergang in zumindest zwei Stufen mit jeweils weniger als 90°, also z.B. jeweils 45° oder z.B. 30° und 60° erfolgt. Die Größe der Fase ist dabei der Abstand zwischen diesen beiden Stufen, wobei die Größe im Bereich von 0,1 mm bis 2 mm liegt, bevorzugt im Bereich von 0,5 mm bis 1,5 mm, besonders bevorzugt von 0,75 mm bis 1,0 mm.

Durch das Vorsehen von Verrundungen und/oder Fasen, welche den gesamten äußeren Rand des Grundkörpers erfassen, werden scharfe Ecken und Kanten vermieden. Hierdurch wird zum einen eine gleichmäßige äußere Kante des Grundkörpers bereitgestellt, welche mechanisch stabil ist. Zum anderen wird verhindert, dass bei Behandlung vieler Grundkörper oder vieler Durchführungen mit dem Grundkörper als Schüttgut scharfe äußere Kanten gegen Flächen oder Kanten anderer Grundkörper oder Durchführungen schlagen und diese dabei beschädigen. Das ist insbesondere dann vorteilhaft, wenn der Grundkörper der Durchführung einen Dichtbereich aufweist, der eben und glatt ist. Kerben oder unerwünschte Rauheiten, welche durch Aneinanderschlagen mehrerer Durchführungen bzw. der Grundkörper entstehen, können eine Dichtwirkung beim Zusammenwirken des Dichtbereichs mit einem Dichtungselement wie einem O-Ring beeinträchtigen.

Der Grundkörper kann weitere Öffnungen umfassen, welche als Befestigungsöffnungen dienen. Durch die Befestigungsöffnungen kann die Durchführung beispielsweise über Schrauben an einem Gehäuseteil befestigt werden.

Zumindest die Öffnungen, durch die ein elektrischer Leiter hindurchgeführt ist und mit dem Fixiermaterial gehalten ist, weisen bevorzugt eine scharfe Kante am Übergang einer Innenwandung der Öffnung zu den Oberflächen der Oberseite und der Unterseite des Grundkörpers auf. Eine Kante wird insbesondere dann als scharf angesehen, wenn diese nicht mit einer Verrundung oder mit einer Fase versehen ist bzw. eine Verrundung oder Fase aufweist, welche einen Radius bzw. eine Größe von weniger als 0,1 mm, besonders bevorzugt von weniger als 0,2 mm und am meisten bevorzugt von weniger als 0,1 mm aufweist.

Scharfe Kanten am Übergang zu den Innenwänden der Öffnung weisen den Vorteil auf, dass das Fixiermaterial und die Innenwandung an einer geraden vertikalen Wand aneinanderstoßen. Bei einer Verrundung oder einer Fase würde sich die Wand im Bereich des oberen Abschlusses des Fixiermaterials von dem Fixiermaterial weg krümmen und damit eine Verbindung zwischen diesen schwächen. Bei mechanischer Belastung könnten in diesem Bereich Teile des Fixiermaterials abplatzen und die Durchführung insgesamt schwächen oder undicht werden lassen.

Des Weiteren kann entlang der Außenkante bzw. Außenkontur des Grundkörpers eine oder mehrere Kerben angeordnet sein. Durch diese Kerben kann bei einem ansonsten entlang einer oder mehrerer Punkte oder entlang einer oder mehrerer Ebenen symmetrisch ausgestalteter Grundkörper eindeutig orientiert werden. Insbesondere kann damit die Oberseite des Grundkörpers von dessen Unterseite unterscheidbar gemacht werden. Bei den Stanzprozessen ergibt sich üblicherweise ein Unterscheid zwischen der Oberseite und der Unterseite eines Bauteils über eine leichte Biegung oder Wölbung, wobei die Oberseite beispielsweise leicht konvex und die Unterseite leicht konkav gewölbt sein kann. Für den Einbau der Durchführung in ein Gehäuse kann dabei jeweils eine der Orientierungen vorteilhafter als die jeweils andere sein.

Der elektrische Leiter besteht aus einem elektrisch leitenden Leitermaterial, wie z. B. einem Metall. Vorzugsweise besteht der mindestens eine elektrische Leiter aus einem Leitermaterial, das aus der Gruppe ausgewählt wird, die Stahl, insbesondere Edelstahl, eine Nickel-Eisen-Legierung und Kupfer umfasst. Darüber hinaus kann der Leiter einen Kern aus einem hochleitfähigen Material, wie z. B. Kupfer, und ein anderes Material als Außenhülle aufweisen.

Das Fixiermaterial ist bevorzugt ein Glasmaterial, ein Glaskeramikmaterial oder ein Keramikmaterial. Alternativ kann das Fixiermaterial auch ein Kunststoff sein. Das Fixiermaterial ist ein elektrischer Isolator. Über das Fixiermaterial wird der elektrische Leiter in der Öffnung des Grundkörpers gehalten und elektrisch gegenüber dem Grundkörper isoliert. Des Weiteren dichtet das Fixiermaterial gegen die Innenwand der Öffnung und den elektrischen Leiter die Öffnung ab.

Vorzugsweise bilden der Grundkörper, der mindestens eine Leiter und das Fixiermaterial eine Metall-Fixiermaterial-Durchführung in Form einer Druckeinglasung. Dementsprechend wird ein erster Wärmeausdehnungskoeffizient des Grundkörpers vorzugsweise größer als ein zweite Wärmeausdehnungskoeffizient des Fixiermaterials gewählt. Um eine Druckeinglasung zu erhalten, sollte der Unterschied zwischen dem ersten und dem zweiten Wärmeausdehnungskoeffizienten in dem Temperaturbereich von 300 K bis 600 K vorzugsweise mindestens 2 ppm/K und weiter bevorzugt mindestens 5 ppm/K betragen. Ein dritter Wärmeausdehnungskoeffizient des Leitermaterials des elektrischen Leiters wird vorzugsweise so gewählt, dass dieser etwa gleich ist oder kleiner ist als der zweite Wärmeausdehnungskoeffizient des Fixiermaterials. Zwei Wärmeausdehnungskoeffizienten werden als ungefähr gleich angesehen, wenn die Differenz weniger als 2 ppm/K beträgt.

Alternativ zu einer Druckeinglasung können das Material des Grundkörpers, das Fixiermaterial und das Leitermaterial so gewählt werden, dass ihre jeweiligen Wärmeausdehnungskoeffizienten ungefähr gleich sind, wobei eine Differenz von weniger als 2 ppm/K als ungefähr gleich angesehen wird. In dieser Variante bilden der Grundkörper, der mindestens eine Leiter und das Fixiermaterial eine angepasste Metall-Fixiermaterial-Durchführung aus.

Die gebildete Metall-Fixiermaterial-Durchführung ist bevorzugt hermetisch dicht, wobei eine Durchführung mit einer He Leckrate von weniger als 1•10⁻⁷ mbar I/s, bevorzugt weniger 1•10⁻⁸ mbar I/s bei einer Druckdifferenz von 1 bar als hermetisch dicht angesehen wird.

Die hierin beschriebenen elektrischen Durchführungen sind insbesondere für Kompressoren geeignet. Dabei sind die elektrischen Durchführungen besonders für Anwendungen in elektrisch angetriebenen Kompressoren, sogenannten E-Kompressoren, geeignet, welche zur Kühlung des Innenraums elektrisch angetriebener Fahrzeuge eingesetzt werden.

Entsprechend ist die elektrische Durchführung bevorzugt als ein Anschlussterminal für einen E-Kompressor ausgebildet.

Ein weiterer Aspekt der Erfindung betrifft ein Verfahren zur Herstellung der hierin beschriebenen elektrischen Durchführungen. Dabei wird ein Rohling für den Grundkörper bereitgestellt und der verstärkte Randbereich wird mittels Schubumformen umgeformt. Durch das Schubumformen wird der Randbereich vertikal gegenüber einer Grundebene des Rohlings versetzt. In nachfolgenden Verfahrensschritten kann ein Fixiermaterial-Pressling und ein elektrischer Leiter in eine Öffnung im Grundkörper eingesetzt werden, wobei über eine sich anschließende Temperaturbehandlung das Fixiermaterial ausgebildet wird, welches dann die Öffnung abdichtet und den Leiter fixiert.

Die Erfindung soll nachfolgend anhand der Figuren und ohne Beschränkung hierauf eingehender beschrieben werden. Gleiche Bezugszeichen bezeichnen dabei gleiche oder ähnliche Elemente.

Es zeigen:
Fig. 1: ein Schnitt durch einen Grundkörper für eine elektrische Durchführung gemäß dem Stand der Technik,
Fig. 2: ein erstes Ausführungsbeispiel eines Grundkörpers in einer schematischen Schnittansicht von der Seite,
Fig. 3: ein zweites Ausführungsbeispiel eines Grundkörpers in einer schematischen Schnittansicht von der Seite,
Fig. 4: eine perspektivische Ansicht des Grundkörpers gemäß dem zweiten Ausführungsbeispiel,
Fig. 5: ein Beispiel für eine elektrische Durchführung in einer Schnittansicht von der Seite,
Fig. 6: ein drittes Ausführungsbeispiel eines Grundkörpers in einer schematischen Schnittansicht von der Seite,
Fig. 7a bis 7c: eine Darstellung einer Finite-Elemente Simulation der Durchbiegung eines Grundkörpers gemäß dem Stand der Technik,
Fig. 8a bis 8c: eine Darstellung einer Finite-Elemente Simulation der Durchbiegung eines Grundkörpers gemäß dem zweiten Ausführungsbeispiel.

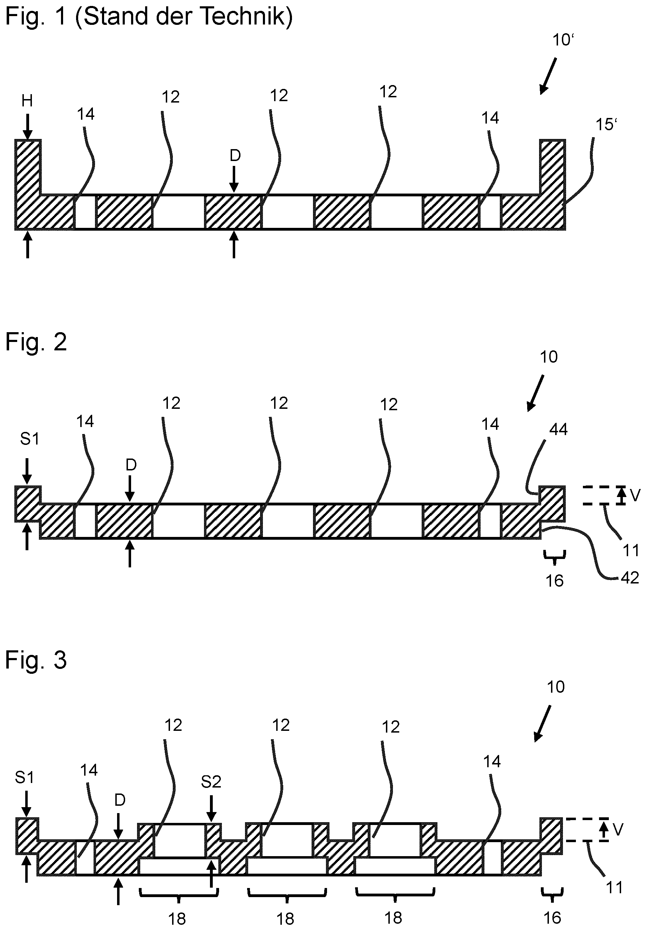

Figur 1 zeigt schematisch einen Schnitt durch einen Grundkörper 10' für eine elektrische Durchführung gemäß dem Stand der Technik.

Der Grundkörper 10' weist in dem dargestellten Beispiel drei Öffnungen 12 auf, durch die ein elektrischer Leiter hindurchgeführt werden kann. Zusätzlich weist der Grundkörper 10' zwei Befestigungsöffnungen 14 auf, über die dieser z.B. mittels Schrauben mit einem Gehäuse verbunden werden kann.

Der Grundkörper 10' ist im Wesentlichen flach und rechteckig ausgebildet, wobei der Grundkörper 10' an seiner Außenkontur zur mechanischen Verstärkung einen umgeformten Rand 15' aufweist. Der umgeformte Rand 15' wurde aus einem flachen Rohling unter Verwendung mehrerer Umformschritte erhalten. Dabei kann der Rohling mit einem Stempel in ein Formwerkzeug gepresst werden, wobei Material des Rohlings in dem Formwerkzeug fließt und den umgeformten Rand 15' ausbildet. Ein Faserverlauf bzw. metallurgische Fließlinien ändern entsprechend an einem Übergang zu dem umgeformten Rand 15' ihre Richtung.

Der umgeformte Rand 15' weist eine Höhe H auf, welche immer größer ist als eine Dicke des Rohlings und größer ist als eine Dicke D des Grundkörpers 10' außerhalb des umgeformten Rands 15'. Entsprechend wird gegenüber einem Grundkörper 10' ohne umgeformten Rand 15' für einen Grundkörper 10' mit denselben Abmessungen in der Länge und Breite aber mit dem umgeformten Rand 15' mehr Material benötigt. Des Weiteren ist der umgeformte Rand 15' durch die erforderlichen Umformschritte vergleichsweise aufwendig in der Herstellung. Die Weite W, welche die Dicke des umgeformten Rands 15' darstellt, entspricht durch das Tiefziehverfahren üblicherweise der Dicke D des Rohlings oder ist geringer als die ursprüngliche Dicke D des Rohlings. Mittels Tiefziehen ist es nicht möglich, die Weite W größer als die ursprüngliche Materialdicke D des Rohlings zu wählen, so dass die Gestaltungsmöglichkeiten beschränkt sind.

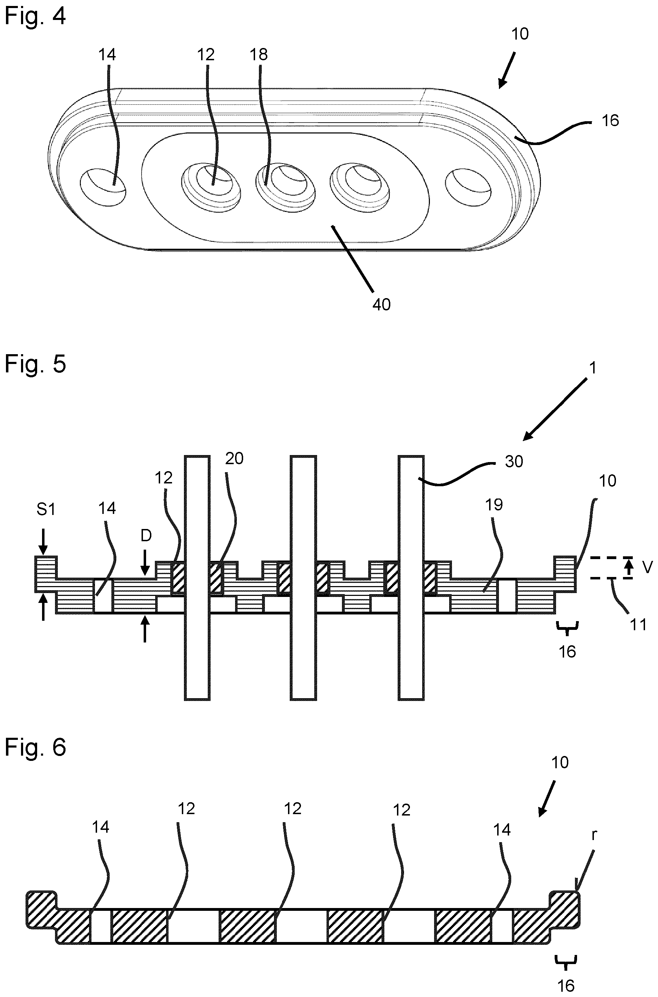

Figur 2 zeigt in einer schematischen Schnittdarstellung von der Seite ein erstes Beispiel für einen Grundkörper 10 für eine elektrische Durchführung 1, vergleiche Figur 5.

Der Grundkörper 10 weist eine im Wesentlichen flache, rechteckige Form auf mit einer Länge L, einer Breite B und einer Dicke D. Der Grundkörper 10 weist in dem dargestellten ersten Beispiel drei Öffnungen 12 auf, durch die jeweils ein elektrischer Leiter 30 hindurchgeführt werden kann. Zusätzlich weist der Grundkörper 10 zwei Befestigungsöffnungen 14 auf, über die dieser z.B. mittels Schrauben mit einem Gehäuse verbunden werden kann.

Zur mechanischen Verstärkung des Grundkörpers 10 ist dieser mit einem erhöhten Randbereich 16 versehen, der gegenüber einer Grundebene 11 des Grundkörpers 10 um eine Strecke V vertikal versetzt ist. Die Materialstärke des Grundkörpers 10 bleibt dabei unverändert, so dass eine Materialstärke S1 im Randbereich 16 der Dicke D des Grundkörpers außerhalb des Randbereichs 16 entspricht. Die Weite W, welche die Dicke des Randbereichs 16 darstellt, kann hier frei gewählt werden und kann somit insbesondere auch weiter gewählt werden als die Dicke D des Grundkörpers 10.

Durch das vertikale Verschieben des Materials zum Erhalten des erhöhten Randbereichs 16 entsteht an der Unterseite des Grundkörpers 10 komplementär dazu eine Stufe 42. Diese Stufe 42 kann als ein mechanischer Anschlag bzw. als eine Zentrierhilfe dienen, wenn die elektrische Durchführung 1 mit dem Grundkörper 10 in eine Öffnung eines Gehäuses eingesetzt wird.

An der Oberseite des Grundkörpers 10 bildet der erhöhte Randbereich eine Wand 44 aus. Diese kann als ein mechanischer Anschlag bzw. als eine Zentrierhilfe für ein zusätzliches Isolationselement (nicht dargestellt) dienen, welches auf die elektrische Durchführung 1 aufgesetzt werden kann.

Figur 3 zeigt in einer schematischen Schnittdarstellung von der Seite ein zweites Beispiel für einen Grundkörper 10. Dieser weist wie bereits mit Bezug zu dem ersten Beispiel der Figur 2 beschrieben eine im Wesentlichen flache, rechteckige Form auf und ist mit drei Öffnungen 12 für das Hindurchführen elektrischer Leiter 30, vergleiche Figur 5, versehen. Ebenso sind wieder zwei Befestigungsöffnungen 14 vorgesehen, um den Grundkörper 10 mit einem Gehäuse verschrauben zu können.

Der Grundkörper 10 gemäß dem zweiten Beispiel weist zusätzlich zu dem erhöhten Randbereich 16 drei Verstärkungsbereiche 18 auf. Die Verstärkungsbereiche 18 sind jeweils als Erhöhung ausgebildet und umgeben jeweils eine der Öffnungen 12. Alternativ dazu könnte auch ein einziger erhöhter Verstärkungsbereich 18 vorgesehen werden, der alle drei Öffnungen 12 umgibt. Die Befestigungsöffnungen 14 befinden sich hier jeweils außerhalb der Verstärkungsbereiche 18. Die Verstärkungsbereiche 18 sind gegenüber der Grundebene 11 des Grundkörpers 10 vertikal um eine Strecke V versetzt. Die Materialstärke des Grundkörpers 10 bleibt dabei unverändert, so dass eine Materialstärke S2 in den Verstärkungsbereichen 18 der Dicke D des Grundkörpers 10 außerhalb der Verstärkungsbereiche 18 entspricht. Die vertikale Versetzung kann, wie in der Figur 3 skizziert, der vertikalen Versetzung um die Strecke V des Randbereichs 16 entsprechen. Alternativ dazu können die Verstärkungsbereiche 18 um eine andere Strecke vertikal versetzt sein.

In Figur 4 ist der Grundkörper 10 der Figur 2 in einer perspektivischen Ansicht dargestellt. Dabei ist gut zu erkennen, dass der erhöhte Randbereich 16 vollständig um den Grundkörper 10 umlaufend ausgestaltet ist. Alternativ dazu könnte der erhöhte Randbereich 16 auch nur an Teilen der Außenkontur des Grundkörpers 10 vorgesehen sein, beispielsweise nur an den langen Kanten des länglichen Grundkörpers 10.

In der Darstellung der Figur 4 ist zudem erkennbar, dass sich an der Unterseite des Grundkörpers 10 um die Öffnungen 12 herum ein Dichtbereich 40 befindet. Dieser Dichtbereich 40 ist eben und glatt ausgestaltet und dient bei Montage der Durchführung 1, vergleiche Figur 5, an einem Gehäuse dazu, mit einem Dichtmittel wie einem O-Ring gegen das Gehäuse abzudichten.

Figur 5 zeigt in einer schematischen Schnittdarstellung von der Seite ein Beispiel für eine elektrische Durchführung 1 mit einem Grundkörper 10. Der Grundkörper 10 ist in diesem Beispiel wie bereits mit Bezug zur Figur 3 beschrieben ausgestaltet und weist den verstärkten Randbereich 16 an der Außenkontur und die erhöhten Verstärkungsbereiche 18 um die Öffnungen 12 herum auf.

Durch die Öffnungen 12 ist jeweils ein elektrischer Leiter 30 hindurchgeführt. Die elektrischen Leiter 30 werden jeweils mit einem Fixiermaterial 20, beispielsweise ein Glas- oder Glaskeramikmaterial, in der Öffnung 12 gehalten. Das Fixiermaterial 20 dient als elektrischer Isolator und isoliert den elektrischen Leiter 30 gegenüber dem Grundkörper 10. Zudem verschließt das Fixiermaterial 20 die Öffnung 12 und dichtet dabei gegen eine Innenwandung der Öffnung 12 und den elektrischen Leiter 30 ab. In dem in Figur 5 gezeigten Beispiel ist zu erkennen, dass metallurgische Fließlinien 19 des Metallmaterials des Grundkörpers 10 parallel zur Längsrichtung orientiert sind. Hierdurch wird die Biegesteifigkeit des Grundkörpers 10 weiter gesteigert.

Figur 6 zeigt ein weiteres Beispiel für einen Grundkörper 10 in einer schematischen Schnittdarstellung von der Seite. Der Grundkörper 10 der Figur 6 ist ähnlich wie bereits mit Bezug zur Figur 2 beschrieben aufgebaut und weist einen erhöhten Randbereich 16 auf. Zusätzlich zu dem mit Bezug zur Figur 2 beschriebenen Beispiel sind bei dem Grundkörper 10 der Figur 6 alle Kanten der Außenkontur mit einer Verrundung r versehen. Innenliegende Kanten, wie Kanten an den Öffnungen 12 sind nicht verrundet und somit scharf ausgeführt.

Die Verrundungen r an den Außenkanten sorgen dafür, dass bei Behandlung einer Vielzahl von Grundkörpern 10 als Schüttgut keine Kratzer oder Kerben entstehen, wenn eine der Außenkanten eines Grundkörpers 10 gegen einen anderen Grundkörper 10 schlägt. Dies ist insbesondere wichtig für die Dichtfläche 40, vergleiche Figur 4, welche zum Erreichen einer optimalen Dichtwirkung glatt und eben bleiben muss.

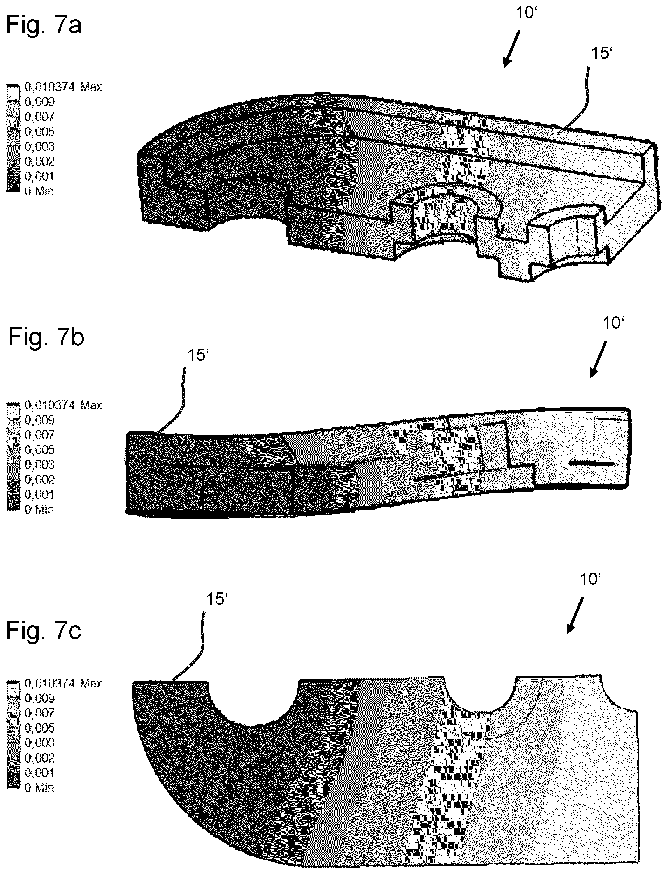

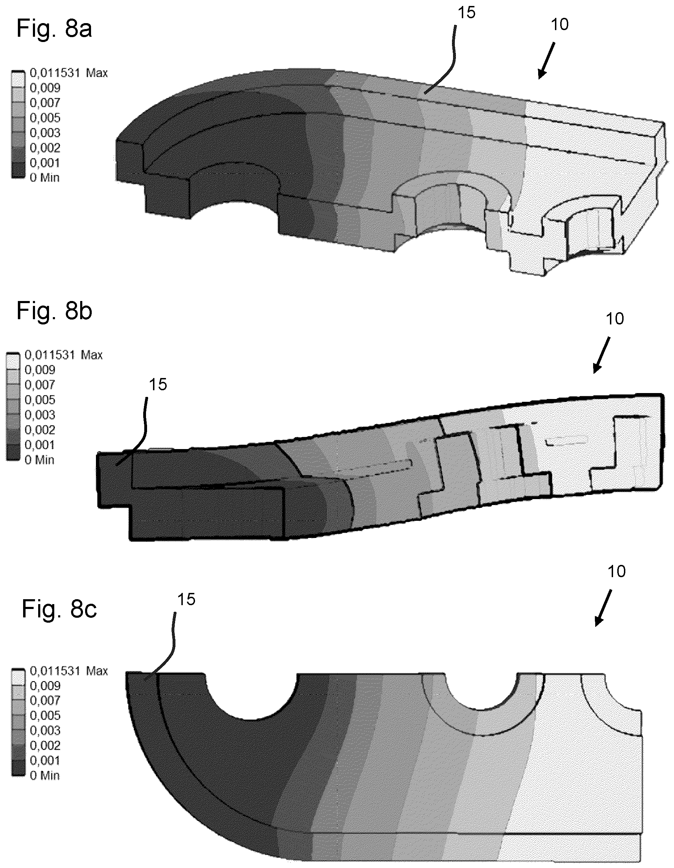

In den Figuren 7a bis 7c und 8a bis 8c sind jeweils Ergebnisse von Finite-Elemente Simulationen dargestellt, welche die Durchbiegung eines Grundkörpers 10 bei Beaufschlagung eines Drucks von 25 bar zeigen. Dabei zeigen die Figuren 7a bis 7c die Durchbiegung eines Grundkörpers 10' mit umgeformten Rand 15' gemäß dem Stand der Technik und die Figuren 8a bis 8c zeigen die Durchbiegung für einen erfindungsgemäßen Grundkörper 10 mit erhöhtem Randbereich 15 und erhöhten Verstärkungsbereichen 18. Für eine bessere Vergleichbarkeit ist auch der Grundkörper 10' mit dem umgeformten Rand 15' gemäß dem Stand der Technik mit erhöhten Verstärkungsbereichen versehen.

In beiden Fällen wurde für den im Wesentlichen rechteckigen Grundkörper 10, 10' eine Länge von 71 mm bei einer Breite von 26 mm gewählt. Als Materialstärke wurde 3 mm gewählt.

Die Figuren 7a und 8a zeigen jeweils einen Ausschnitt einer perspektivischen Darstellung, die Figuren 7b und 8b zeigen eine Schnittansicht von der Seite und die Figuren 7c und 8c zeigen einen Ausschnitt einer Draufsicht auf den Grundkörper 10, 10'. In den Schnittansichten von der Seite der Figuren 7b und 8b ist die Durchbiegung für eine bessere Sichtbarkeit um den Faktor 300 übertrieben dargestellt. Die Auslenkung des Grundkörpers 10, 10' ist über die Graustufen gekennzeichnet.

Bei dem Grundkörper 10' gemäß dem Stand der Technik wird eine maximale Verbiegung von 0,010374 mm ermittelt. Bei dem erfindungsgemäßen Grundkörper 10 wird eine maximale Verbiegung von 0,011531 mm ermittelt. Der erfindungsgemäße Grundkörper 10 ist somit bei geringerem Materialeinsatz fast genauso biegesteif wie der Grundkörper 10' des Stands der Technik mit dem umgeformten Rand 15'. Entsprechend ermöglicht die Verstärkungsstruktur in Form des erhöhten Rands 15 eine mechanische Versteifung des Grundkörpers 10, ohne dass zusätzliches Material erforderlich ist. Des Weiteren ist der erhöhte Rand 15 durch vertikales Verschieben des Materials des Grundkörpers 10 herstellbar, so dass aufwendige Umformschritte wie Tiefziehen entfallen.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- 1: elektrische Durchführung
- 10: Grundkörper
- 11: Grundebene
- 12: Öffnung
- 14: Befestigungsöffnung
- 15': umgeformter Rand
- 16: erhöhter Randbereich
- 18: erhöhter Verstärkungsbereich
- 19: metallurgische Fließlinien

- 20: Fixiermaterial

- 30: elektrischer Leiter

- 40: Dichtungsbereich
- 42: Stufe
- 44: Wand

- r: Verrundung

- D: Dicke Grundkörper
- H: Höhe Rand
- W: Weite Rand
- S1: Stärke Randbereich
- S2: Stärke Verstärkungsbereich
- V: vertikaler Versatz

## Patentansprüche

1. Elektrische Durchführung (1) umfassend einen Grundkörper (10) mit mindestens einer Öffnung (12), durch die ein elektrischer Leiter (30) hindurchgeführt ist und in der Öffnung (12) über ein Fixiermaterial (20) gehalten ist, wobei das Fixiermaterial (20) die Öffnung (12) verschließt und wobei der Grundkörper (10) eine längliche Form aufweist und zumindest an den Rändern der langen Seiten eine Verstärkungsstruktur aufweist, **dadurch gekennzeichnet, dass** die Verstärkungsstruktur als erhöhter Randbereich (16) ausgeführt ist, der gegenüber einer Grundebene (11) des Grundkörpers (10) vertikal versetzt ist.

2. Elektrische Durchführung (1) nach Anspruch 1, **dadurch gekennzeichnet, dass** der erhöhte Randbereich (16) vertikal gegenüber der Grundebene (11) des Grundkörpers (10) versetzt ist, wobei eine Stärke (S1) des Randbereichs (16) einer Dicke (D) des Grundkörpers (10) entspricht.

3. Elektrische Durchführung (1) nach Anspruch 1 oder 2, **dadurch gekennzeichnet, dass** um die mindestens eine Öffnung (12) herum ein erhöhter oder vertiefter Verstärkungsbereich (18) ausgebildet ist, wobei der erhöhte oder vertiefte Verstärkungsbereich (18) vertikal gegenüber einer Grundebene (11) des Grundkörpers (10) versetzt ist und wobei eine Stärke (S2) des erhöhten oder vertieften Verstärkungsbereichs (18) einer Dicke (D) des Grundkörpers (10) entspricht.

4. Elektrische Durchführung (1) nach einem der Ansprüche 1 bis 3, **dadurch gekennzeichnet, dass** der erhöhte Randbereich (16) und/oder der erhöhte oder vertiefte Verstärkungsbereich (18) um weniger als die Dicke (D) des Grundkörpers (10) gegenüber einer Grundebene (11) des Grundkörpers (10) versetzt ist.

5. Elektrische Durchführung (1) nach Anspruch 4, **dadurch gekennzeichnet, dass** der erhöhte Randbereich (16) und/oder der erhöhte oder vertiefte Verstärkungsbereich (18) in Bezug auf die Dicke (D) des Grundkörpers (10) im Bereich von 20 % bis 80% in vertikaler Richtung versetzt ist.

6. Elektrische Durchführung (1) nach einem der Ansprüche 1 bis 5, **dadurch gekennzeichnet, dass** die Dicke (D) des Grundkörpers (10) über alle Bereiche konstant ist.

7. Elektrische Durchführung (1) nach einem der Ansprüche 1 bis 6, **dadurch gekennzeichnet, dass** das Material des Grundkörpers (10) ein Metall ausgewählt aus der Gruppe umfassend Stahl, insbesondere unlegierten Stahl wie einem Stahl mit der Materialnummer 1.0338 oder Edelstahl, NiFe, Kovar, Titan und Kupfer ist.

8. Elektrische Durchführung (1) nach Anspruch 7, **dadurch gekennzeichnet, dass** metallurgische Fließlinien des Metallmaterials des Grundkörpers (10) über alle Bereiche des Grundkörpers (10) hinweg in dieselbe Richtung verlaufen, bevorzugt parallel zu der längsten Seite des Grundkörpers (10).

9. Elektrische Durchführung (1) nach einem der Ansprüche 1 bis 8, **dadurch gekennzeichnet, dass** zumindest ein Dichtungsbereich (40) des Grundkörpers (10) eine Abweichung der Ebenheit ≤ 0,1 mm gemäß DIN EN ISO 1101, Stand 09/2017, insbesondere im Bereich 0,005 mm bis 0,02 mm pro 10 mm Länge aufweist.

10. Elektrische Durchführung (1) gemäß einem der Ansprüche 1 bis 9, **dadurch gekennzeichnet, dass** der Grundkörper (10) mit einer Oberflächenbeschichtung versehen ist, insbesondere einer Nickelschicht.

11. Elektrische Durchführung (1) gemäß einem der Ansprüche 1 bis 10, **dadurch gekennzeichnet, dass** der Grundkörper (10) entlang aller Kanten der Außenkontur, mit einer Fase und/oder einer Verrundung (r) versehen ist.

12. Elektrische Durchführung (1) nach einem der Ansprüche 1 bis 11, **dadurch gekennzeichnet, dass** die elektrische Durchführung (1) als Anschlussterminal für einen E-Kompressor ausgebildet ist.

13. Verfahren zur Herstellung einer Elektrischen Durchführung (1) nach einem der Ansprüche 1 bis 12, **dadurch gekennzeichnet, dass** der erhöhte Randbereich (16) mittels Schubumformen umgeformt wird.
